Europäisches Patentamt

European Patent Office

Office européen des brevets

(11) Publication number: **0 022 266**
**B1**

(12) **EUROPEAN PATENT SPECIFICATION**

(45) Date of publication of patent specification: **25.01.84**

(21) Application number: **80103829.0**

(22) Date of filing: **04.07.80**

(51) Int. Cl.³: **H 03 K 19/08,**
**H 01 L 29/78, G 11 C 11/40**

(54) Semiconductor circuit device.

(30) Priority: **10.07.79 JP 86474/79**

(43) Date of publication of application:
**14.01.81 Bulletin 81/2**

(45) Publication of the grant of the patent:
**25.01.84 Bulletin 84/4**

(84) Designated Contracting States:
**DE FR GB NL**

(56) References cited:
**FR - A - 2 161 895**
**FR - A - 2 215 704**

**ELECTRONICS AND COMMUNICATIONS IN
JAPAN, vol. 55, no. 7, July 1972, pages 84-92
Washington, U.S.A. Y. HAYASHI et al.: "Design
theory of ED-MOS-IC"**
**IBM TECHNICAL DISCLOSURE BULLETIN, vol.
14, no. 4, September 1971, pages 1077-1078
New York, U.S.A. D.W. KEMERER: "Storage cell
using double-threshold field-effect transistors"**

(73) Proprietor: **TOKYO SHIBAURA DENKI KABUSHIKI
KAISHA**
**72, Horikawa-cho Saiwai-ku**
**Kawasaki-shi Kanagawa-ken 210 (JP)**

(72) Inventor: **Uchida, Yukimasa**
**1524 Maeda Haitsu 511-2, Maeda-cho Totsuka-
ku**
**Yokohama-shi Kanagawa-ken (JP)**

(74) Representative: **Patentanwälte Henkel, Pfenning,
Feiler, Hänzel & Meinig**
**Möhlstrasse 37**
**D-8000 München 80 (DE)**

(56) References cited:
**IBM TECHNICAL DISCLOSURE BULLETIN, vol.
10, no. 7, December 1967, page 1032 New
York, U.S.A. J.J. McDOWELL: "Use of the MOS
substrate as a control element"**
**INTERNATIONAL ELECTRON DEVICES
MEETING, Technical Digest, 6th-8th December
1976, pages 185-187 Washington, U.S.A. S.
ASAI et al.: "Back-gate-input MOS, a new low-
power logic concept"**

Courier Press, Leamington Spa, England.

## Semiconductor circuit device

The present invention relates to a semiconductor circuit device including an insulated gate field effect transistor to perform a static operation.

In the field of the semiconductor circuit such as an inverting circuit, a remarkable improvement has been attained in the operating speed, a degree of integration, power consumption, and the like. The semiconductor circuit of this type is categorized into two, a static type semiconductor circuit and a dynamic type one. In the static type semiconductor circuit, an output voltage with a fixed level may be continuously obtained by keeping constant an input signal level under the supply of the power source voltage. On the other hand, in the dynamic type semiconductor circuit, it is difficult to keep the output signal level constant, because of the existence of leak current paths contained in the elements constituting the circuit. In respect of a stability of the operation, the static type semiconductor circuit is advantageous over the dynamic type semiconductor circuit.

For example, a conventional MOS type static inverting circuit has a driving MOS transistor whose drain is connected to a resistive element formed of high resistive material or MOS transistor. To reduce the power consumption of the circuit, it is necessary to increase the resistance of the resistive element. Where a MOS transistor is used to form a high resistive element, the channel length/the channel width of the MOS transistor must be made large. An attempt to reduce the channel width encounters a difficulty in its manufacturing technique. For this reason, the channel length must be made longer. This results in an enlarged area occupied by the MOS transistor.

There is an attempt to restrict the occupation area of a load resistive element on a chip within a small area. For this purpose, a technique of forming a polysilicon with a high resistivity of 10 M$\Omega$/$\square$ to 100 M$\Omega$/$\square$, for example, is developed. In another attempt, the high resistive poly-silicon is disposed over the upper portion of a drive transistor, with an intention to minimize the occupation area by the load resistive element. The attempt, however, has failed to reduce the occupation area of the load resistive element to a satisfactory extent. To form the poly-silicon layer of the load resistive element at the upper portion of the drive transistor, it is necessary to use a double layer poly-silicon technique or a multilayer wiring technique. This results in complexity of the manufacturing process. If the load resistive element is formed to have a high resistance, the power consumption of the semiconductor circuit may be made low. In this case, however, a leak current generated at the junction between the drain and the substrate of a drive transistor may cause the drive transistor to erroneously operate. Conversely, when the load resistive element is formed to have a low resistance, the power consumption is increased, so that it is difficult to integrate the semiconductor circuit with a high density.

In making the transistor size small to improve a degree of integration, the channel length or the channel width is set to 1 $\mu$m or less. In this case, it has generally been considered that it is difficult to obtain a semiconductor circuit having a stable operation, due to a short channel effect or a narrow channel effect that the threshold voltage is greatly influenced by the channel length or the channel width.

IBM Technical Disclosure Bulletin, Vol. 10, No. 7, December 1967, page 1032 (McDowell: "Use of the MOS substrate as a control element") discloses a MOS semiconductor circuit device comprising a MOS substrate which is used as a control element. The potential on a substrate terminal of the MOS device can be varied to perform logic, control and level-setting functions. The MOS device can be turned on or off by varying the potential at the substrate terminal as the current flow from source to drain, or vice versa, depends on the reverse biasing of the source-substrate and drain-substrate junctions.

Furthermore, IBM Technical Disclosure Bulletin, Vol. 14, No. 4, September 1971, pages 1077—1078 (Kemberer: "Storage cell using double threshold field effect transistors") describes a storage cell using cross-connected field effect transistors (FETs) whose drain terminals are connected with earth and double-threshold FETs which connect internal switching nodes of the storage cell to bit sense line. The use of these double-threshold enables a considerable reduction in chip space allocation.

Accordingly, an object of the present invention is to provide a semiconductor circuit device with a small power consumption which can be integrated with a high density.

According to one aspect of the invention, there is provided a semiconductor circuit device comprising: input and output terminals, a first insulated gate field effect transistor having a semiconductor substrate, source and drain regions formed in the surface area of said semiconductor substrate, a gate electrode insulatively disposed on said semiconductor substrate between said source and drain regions, said gate electrode and said drain region being respectively connected to said input and output terminals, and power source means for applying a forward voltage to a PN junction formed between said semiconductor substrate and said source region, said semiconductor circuit device being characterized in that said forward voltage is substantially constant and is not larger than a built-in potential difference at said PN junction.

According to another aspect of the invention, there is provided a semiconductor circuit comprising a first insulated gate field effect transistor and a second insulated gate field effect transistor of the same channel type as that of said first insulated gate field effect transistor, of which the gate electrode, the drain region and the source region are respectively connected to the drain region, the gate electrode and the source region of said first insulated gate field effect transistor, said semiconductor circuit being characterized by further comprising power source means for applying to first and second PN junctions respectively formed between the substrates and the source regions of said first and second insulated gate field effect transistors a substantially constant voltage not larger than the built-in potential differences at said first and second PN junctions.

This invention can be more fully understood from the following detailed description when taken in conjunction with the accompanying drawings, in which:

Fig. 1 is a circuit diagram of an inverting circuit according to an embodiment of the present invention;

Fig. 2 is a cross sectional view of part of a semiconductor device constituting the inverting circuit shown in Fig. 1;

Fig. 3 is a circuit diagram of a memory cell according to another embodiment of the present invention;

Fig. 4 is a memory cell array including memory cells arranged in a matrix form and having the same construction as that of the memory cell shown in Fig. 3;

Fig. 5 is a circuit diagram of an inverting circuit of another embodiment according to the present invention;

Fig. 6 is a modification of a memory cell shown in Fig. 3; and

Fig. 7 shows a memory cell array including memory cells arranged in a matrix form and having the same construction as that of the memory cell shown in Fig. 6.

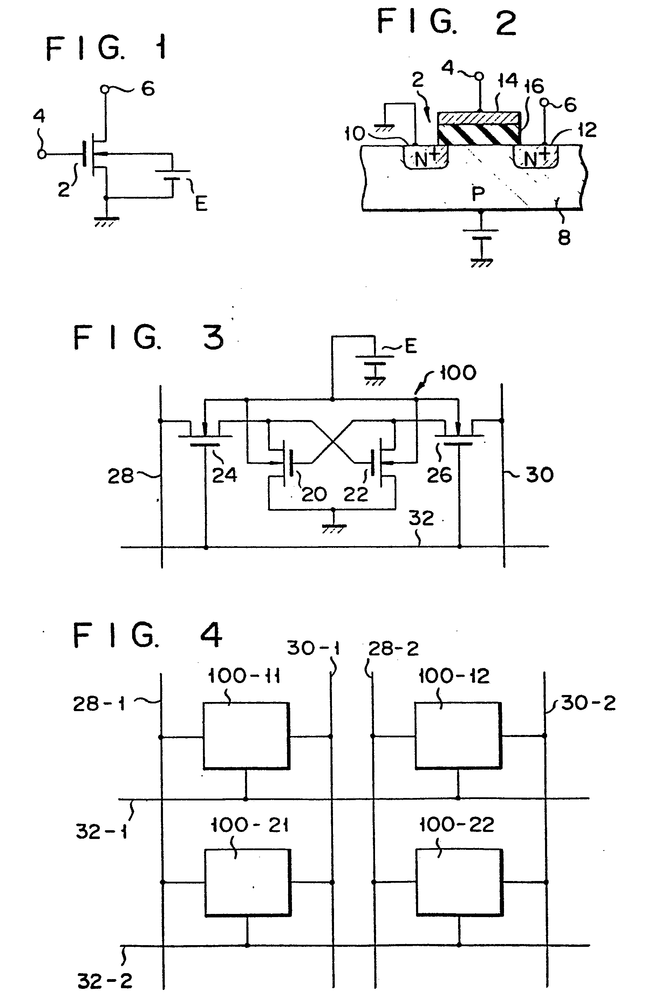

Fig. 1 is a circuit diagram of an inverting circuit according to an embodiment of the present invention and Fig. 2 is a schematic cross sectional view of the semiconductor device of the same embodiment. The inverting circuit has an N channel enhancement type MOS FET 2 whose source is grounded. The gate and drain of the MOS FET 2, are, respectively, connected to an input terminal 4 and an output terminal 6. The substrate is biased forwardly with respect to the source by a DC power source E generating an output voltage Vo, for example, 0.4V which is smaller in an absolute value than a contact potential difference or built-in potential $\phi_B$ at the PN junction between the source and the substrate. In constructing a bistable circuit by using a pair of inverting circuits which have the same construction as the inverting circuit shown in Fig. 1, the absolute value of the threshold voltage $V_{TH}$ of

the MOS FET 2 is selected to be smaller than the output voltage Vo of the power source E. This is not essential to the other cases than a case where the inverting circuit is used to constitute a flip-flop circuit.

As shown in Fig. 2, source and drain regions 10 and 12 are formed in the surface region of a P type silicon substrate 8 with an acceptor impurity concentration of $10^{15}$ atoms/cm³. The source and drain regions 10 and 12 are N+ type regions doped with doner type impurity such as arsenic impurity or phosphorus impurity, with a high concentration, in a thermal diffusion or an ion plantation. A conductive gate electrode 14 is formed over the surface of the substrate 8 between the source and drain regions, and parts of the source and drain regions 10 and 12, and a gate insulating layer 16 interposed between the gate electrode and the substrate. The gate insulating layer 16 is an oxide silicon layer with 100 Å of thickness, for example. The gate electrode 14 may be made of metal such as aluminum or molybdenum or poly-silicon doped with impurity. For reducing a temperature-dependancy of the difference between work function of the gate electrode 14 and the substrate 8, it is preferable to form the gate electrode of poly-silicon doped with the same type impurity as that of the silicon substrate 8.

In a case where a forward voltage smaller in an absolute value than a built-in potential difference $\phi_B$ at the PN junction between the source and the substrate is applied between the source and the substrate, the threshold voltage $V_{TH}$ of the MOS transistor is given as follows:

$$V_{TH} = V_{FB} + (\phi_S - V_o) + \frac{T_{ox}}{\varepsilon_{ox}}(-Q_D) \qquad (1)$$

where $\phi_S$ is a surface potential measured with respect to a point within a bulk or a point within the substrate at an instant that a weak inversion layer takes place in the surface area of the silicon substrate 8, Vo is a forward voltage applied between the source and the substrate and is set at 0.4V in this example, $T_{ox}$ is the thickness of the gate insulating layer 16, and $\varepsilon_{ox}$ is a dielectric constant of the gate insulating layer 16. $Q_D$ represents an amount of charge of acceptor impurity ionized in a depletion layer under the surface of the substrate 8 and is expressed as follows:

$$Q_D = \sqrt{2q \cdot \varepsilon_{si} \cdot N_A(\phi_S - V_o)} \qquad (2)$$

where q is a unit charge amount, $N_A$ is an acceptor impurity concentration in the P type silicon substrate 8, $\varepsilon_{si}$ is a dielectric factor of the silicon substrate 8. $V_{FB}$ indicates a flat band voltage and is given by the following equation:

$$V_{FB} = \frac{T_{ox}}{\varepsilon_{ox}}(-Q_{SS}) + \phi_{MS} \qquad (3)$$

where $Q_{SS}$ is an amount of charge caused by the surface state or an equivalent surface charge imaginarily existing on the surface of the substrate 8 which has an influence similar to that of the charge actually existing within the insulating layer 16, and $\phi_{MS}$ is a work function difference between the silicon substrate 8 and the gate electrode 14.

For example, about 0.5V is set as a surface potential $\phi_S$ when a weak inversion layer is formed in the surface region of the P type silicon substrate with $10^{15}$ atoms/cm$^3$ of acceptor impurity concentration, in this embodiment. In this case, the threshold voltage $V_{TH}$ of the MOS transistor is equal to $(V_{FB}+0.12)$ volt. For example, when $V_{FB}=0.13V$, $V_{TH}$ is about 0.25V.

Under this condition, the inverting circuit shown in Fig. 1 serves as a static type inverting circuit. That is, when OV is applied to the input terminal 4, no channel is formed between the drain and source because the input voltage is smaller than the threshold voltage $V_{TH}$. To be more specific, the input voltage is smaller than the flat band voltage, so that an accumulation layer is formed in the surface region of the substrate 8. In this case, no channel is formed between the source region 10 and the drain region 12, so that a channel current $I_{DS}$ which flows through a path between the source region 10 and the drain region 12 is made zero. Since the junction between the source region 10 and the substrate 8 is biased forwardly and the drain region 12 is formed within the surface region of the silicon substrate 8, a leak current $I_L$ flows through a PN junction region between the drain region 12 and the substrate 8. The flow of the leak current $I_L$ holds the potential of the drain region 12 equal to that of the substrate 8, that is, Vo. In this case, the leak current $I_L$ is sufficiently large, compared to the channel current $I_{DS}$, so that the output terminal connected to the drain region 12 is kept at Vo.

Assuming that 0.4V of the input voltage is applied to the input terminal 4, a channel is formed between the source region 10 and the drain region 12 because the input voltage is higher than the threshold $V_{TH}$ ($=0.25V$) of the MOS transistor 2. In this case, the channel current $I_{DS}$ flowing between the source region and the drain region through the channel is much larger than the leak current $I_L$ flowing through the PN junction between the drain region 12 and the substrate 8. Accordingly, the potential at the drain region 12 and the potential at the output terminal 6 are equal to the potential of the source 10 and ground potential, respectively. Afterwards, when the input voltage is set to OV, the channel between the source region 10 and the drain region 12 disappears. As a result, the potential at the output terminal 6 is held at the potential of the substrate 8 by the leak current $I_L$ flowing through the junction between the drain region 12 and the substrate 8, as previously stated. In this case, if a forward bias voltage less than the built-in potential difference $\varphi_B$ is applied to the PN junction, the foward current flowing through the PN junction is very small, so that the currents flowing between the source and substrate and between the drain and the substrate are negligible.

Since a forward bias voltage is applied between the source and the substrate, depletion layers between the source and the substrate and between the drain and the substrate are extremely thin. Therefore, the threshold voltage of the MOS transistor is never greatly influenced by the short channel effect and the narrow channel effect.

Fig. 3 shows a static type memory cell 100 with a bistable circuit composed of a pair of MOS transistors 20 and 22 which each have the same function and construction as those of the MOS transistor 2 shown in Figs. 1 and 2 and may be formed to have the common substrate. The sources of the MOS transistors 20 and 22 are grounded. The gate and drain of the MOS transistor 20 are coupled with the drain and the gate of the MOS transistor 22, respectively. The memory cell 100 has a pair of MOS transistors 24 and 26 which are respectively connected at the sources to the drains of the MOS transistors 20 and 22, at the drains to first and second bit lines 28 and 30, and at the gate to the word line 32. The substrate of the MOS transistors 20, 22, 24 and 26 are coupled with the positive terminal of the power source E. With this connection, a given forward voltage, e.g. 0.4V, with respect to the source, is applied to the substrate of the MOS transistors 20 and 22.

The MOS transistors 24 and 26 are of the enhancement type, and each have a gate insulating layer of 100 Å thickness and a threshold voltage of 0.25V. A voltage of OV or 1.5V is selectively applied to the bit lines 28 and 30. To the word line 32 is applied a two-level signal changing between OV and 2V.

The read and write operations of the memory cell 100 shown in Fig. 3 will be described. When the memory cell 100 stores data "1", the drain of the MOS transistor 20 is at a high potential level and the drain of the MOS transistor 22 at a low potential level (OV). When it stores data "0", the drain of the MOS transistor 22 is at a high potential level and the drain of the MOS transistor 20 is at a low potential level (OV).

For writing data "1" into the memory cell 100, the potentials of the bit lines 28 and 30 are respectively set to $+1.5V$ and OV and the potential of the word line 32 is set to $+2V$. As a result, the MOS transistors 24 and 26 are rendered conductive and the voltage 1.5V on the bit line 28 is applied to the gate of the MOS transistor 22 thereby to render the MOS transistor 22 conductive. The drain voltage of the MOS transistor 22 is kept at OV, so that the MOS transistor 20 is held in a non-conductive state. Then, when the word line potential is set to OV, the MOS transistors 22 and 20 are held in the conductive and non-conductive states, respectively. Further, the drain of the MOS transistor 20, which is in the non-conductive state, is held at the potential equal to at least the substrate potential, since a forward voltage is applied between the substrate and the source. In this way, the memory cell 100 stores the data "1" on the basis of the static operation.

By setting the potentials on the bit lines 28 and 30 to 0V and +1.5V, and setting the potential on the word line 32 to +2V, the MOS transistors 20 and 22 are set in the conductive and non-conductive states, respectively. Then, by setting the potential on the word line 32 to 0V, the MOS transistors 20 and 22 are held in the conductive and non-conductive states, respectively. In this way, the memory cell 100 stores the data "0".

Assume now that the data "1" is stored in the memory cell 100 and the drain voltages of the MOS transistors 20 and 22 are 0.4V and 0V, respectively. For reading out the data "1" from the memory cell 100, the potential on the word line 32 is changed from 0V to 2V under a condition that the bit lines 28 and 30 are both set to 1.5V. Upon the change of the voltage, the MOS transistors 24 and 26 are conductive. At this time, however, the MOS transistor 22 has been conductive, so that the potential on the bit line 30 is forcibly reduced toward the ground potential. Since the MOS transistor 20 is non-conductive, the potential on the bit line 28 is held at 1.5V. In this manner, the data "1" is read out from the memory cell through the bit lines 28 and 30.

The above-mentioned operation is likewise applicable for reading out the data "0" from the memory cell 100. In this case, by changing the potential on the word line 32 from 0V to 2V under a condition that the bit lines 28 and 30 are both kept at 1.5V, the MOS transistors 24 and 26 are both conductive, thereby to forcibly reduce the potential on the bit line 28 toward the ground potential through the MOS transistor 20 which is now conductive. Since the MOS transistor 22 is nonconductive, the potential on the bit line 30 is held at 1.5V. In this way, the data "0" may be read out from the memory cell 100 through the bit lines 28 and 30.

It is possible to construct a memory cell array by using a plurality of the memory cells shown in Fig. 3. In this case, as well illustrated in Fig. 4, memory cells on the same column line, for example, memory cells 100—11 and 10—21, are commonly connected to a pair of bit lines 28—1 and 30—1. The memory cells on the same row line, for example, memory cells 100—11 and 100—12, are commonly connected to the same word line 32—1.

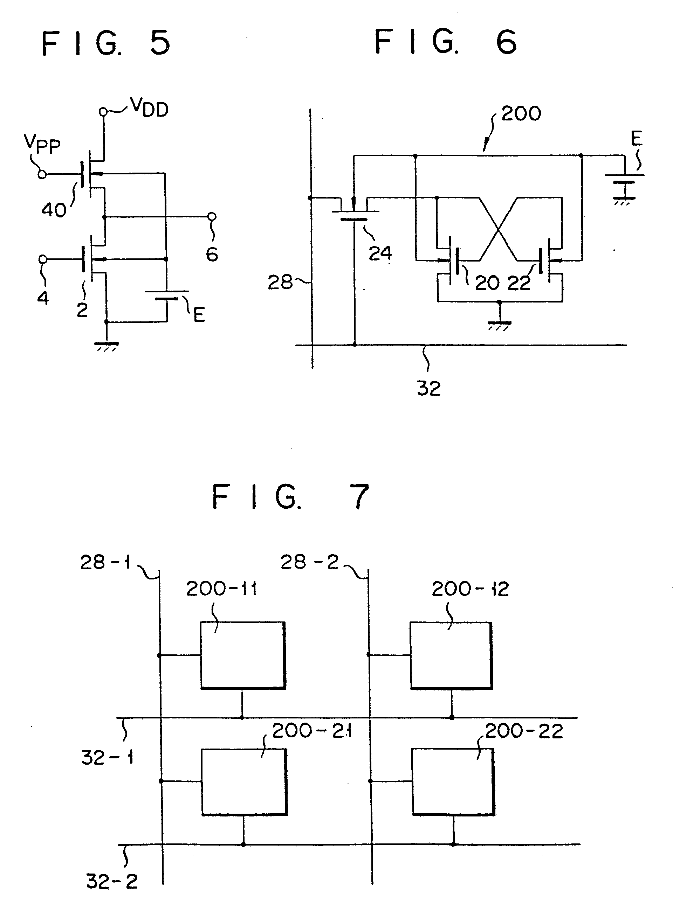

Turning now to Fig. 5, there is shown an inverting circuit according to another embodiment of the present invention. The inverting circuit shown in Fig. 5 is featured by additionally using an N channel MOS transistor 40 which has a source connected to the drain of the MOS transistor 2 and a substrate connected to the positive terminal of the power source E in the circuit shown in Fig. 1. The drain of the MOS transistor 40 is coupled with a power source terminal $V_{DD}$ impressed with a voltage from 0.4V to 2V, for example. The gate of the transistor 40 is coupled with a precharge terminal $V_{pp}$ to which a two-level signal with two levels of 0V and +2V or a precharge pulse is applied immediately before each data is read out. The MOS transistor 40 may be formed in the same manner as the MOS transistor 2 and substrate 8 of the MOS transistor 2 may be commonly used as the substrate of the MOS transistor 40.

In the inverting circuit, when an input voltage becomes 0V, the output voltage changes from 0V to 0.4V. That is, the drain potential of the MOS transistor 2 changes from the source potential to the substrate potential. In this case, by applying the precharge pulse to the gate of the MOS transistor 40, it is possible to set the potential at the output terminal 6 or the source potential of the MOS transistor 40 to a high level at a high speed. When the source of the MOS transistor 40 is precharged in this way, the inverting circuit executes the static operation, as previously stated, to hold the output voltage at a value larger than Vo when an input voltage is 0V and at a 0V when an input voltage is at a high level.

Fig. 6 is a modification of the memory cell shown in Fig. 3. The memory cell is obtained by removing the bit line 30 and the switching transistor 26 from the memory cell shown in Fig. 3. Also in the memory cell, the read and the write operations are performed in the same manner as in the previous case.

For writing the data "1" into the memory cell 200, it is only necessary to set the potential on the bit line 28 to 1.5V and apply a voltage of 2V to the word line 32. Upon this, 1.5V on the line 28 is applied to the gate of the MOS transistor 22, through the MOS transistor 24, thereby to render the MOS transistor 22 conductive. As a result, the gate of the MOS transistor 20 is set at ground potential, so that the MOS transistor 20 becomes non-conductive. For writing the data "0" into the memory cell 200, the potential on the bit line 28 is set to 0V and 2V is applied to the word line 32. Through the operation, 0V is applied to the gate of the MOS transistor 22, by way of the MOS transistor 24, so that the MOS transistor becomes non-conductive. As a result, the output voltage Vo of the battery E appears at the drain of the MOS transistor 22, which is in turn applied to the gate of the MOS transistor 20 thereby to render the MOS transistor 20 conductive.

In the data read mode, the potential on the bit line 28 is set at 0.5V to 1V, for example, and the potential on the word line 32 is set to 2V. When the MOS transistor 20 is non-conductive, thut is, when the data "1" is stored in the memory cell 200, the potential on the bit line 28 is kept at 0.4V or more, so that the data "1" is read out through the bit line 28. When the MOS transistor 20 is conductive, that is, when the data "0" is stored in the memory, the potential on the bit line 28 is lower than the output voltage Vo of the power source E, so that the data "0" is read out through the bit line 28. By arranging in a matrix fashion a plurality of memory cells such as memory cells 200—11 to 200—22 each constructed like the memory cell shown in Fig. 6, a memory cell array may be constructed as shown in Fig. 7.

While the invention has been described in its preferred embodiments, it is to be understood by those skilled in the art that within the scope of the invention, various modifications can be made. For example, the N channel MOS transistors for constructing the inverting circuits and the memory cells may be replaced by P channel MOS transistors. In this case, the polarity of the power source voltage is reversed.

Further, each of the MOS transistors 2 and 40 may be formed as a discrete element, that is, the MOS transistors 2 and 40 may be formed on different substrates.

## Claims

1. A semiconductor circuit device comprising: input and output terminals, a first insulated gate field effect transistor (2, 20) having a semiconductor substrate (8), source and drain regions (10, 12) formed in the surface area of said semiconductor substrate (8), a gate electrode (14) insulatively disposed on said semiconductor substrate (8) between said source and drain regions (10, 12), said gate electrode (14) and said drain region (12) being respectively connected to said input and output terminals, and power source means (E) for applying a forward voltage to a PN junction formed between said semiconductor substrate (8) and said source region (10), characterized in that said forward voltage is substantially constant and is not larger than a built-in potential difference at said PN junction.

2. A semiconductor circuit device according to claim 1, further comprising a second insulated gate field effect transistor (40) with the same channel type as that of said first insulated gate field effect transistor (2), characterized in that said second insulated gate field effect transistor has a current path connected in series with the current path of said first insulated gate field effect transistor (2).

3. A semiconductor circuit device according to claim 1 or 2, characterized in that said first insulated gate field effect transistor (2) is of N channel type.

4. A semiconductor circuit device according to claim 1 or 2, characterized in that the source region (10) of said first insulated gate field effect transistor (20) is grounded, and that the input and output terminals (4 and 6) are connected respectively to said gate electrode (14) and said drain region (12) of said first insulated gate field effect transistor (2).

5. A semiconductor circuit device according to claim 1 or 2, characterized in that said power source means (E) applies to said PN junction a voltage larger than a threshold voltage of said first insulated gate field effect transistor (2).

6. A semiconductor circuit comprising a first insulated gate field effect transistor (20) and a second insulated gate field effect transistor (22) of the same channel type as that of said first insulated gate field effect transistor (20), of which the gate electrode, the drain region and the source region are respectively connected to the drain region, the gate electrode and the source region of said first insulated gate field effect transistor, characterized by further comprising power source means (E) for applying to first and second PN junctions respectively formed between the substrates and the source regions of said first and second insulated gate field effect transistors (20, 22) a substantially constant voltage not larger than the built-in potential differences at said first and second PN junctions.

7. A semiconductor circuit according to claim 6, characterized in that said power source means (E) applies to said first and second PN junctions a voltage larger than the threshold voltages of said first and second insulated gate field effect transistors (20, 22).

8. A semiconductor circuit according to claim 6 or 7, further comprising a first bit line (28), a word line (32), a third insulated gate field effect transistor (24) characterized in that said third insulated gate field effect transistor (24) has a current path connected between the drain of said first insulated gate field effect transistor (20) and said first bit line (28), and a gate connected to said word line (32).

9. A semiconductor circuit according to claim 8, further comprising a second bit line (30) and a fourth insulated gate field effect transistor (26) characterized in that said fourth insulated gate field effect transistor (26) has a current path connected between the drain of said second insulated gate field effect transistor (22) and said second bit line (30), and a gate connected to said word line (32).

## Patentansprüche

1. Halbeiterschaltungsvorrichtung mit Eingangs- und Ausgangsklemmen, mit einem ersten Isolierschicht-Feldeffekttransistor (2, 20), der ein Halbleitersubstrat (8), Source- und Drainzonen (10, 12), die im Oberflächenbereich des Halbleitersubstrats (8) ausgebildet sind, und eine isoliert auf dem Halbleitersubstrat (8) zwischen Source- und Drainzonen (10, 12) angeordnete Gate-Elektrode (14) aufweist, wobei die Gate-Elektrode (14) und die Drainzone (12) mit Eingangs- bzw. Ausgangsklemmen verbunden sind, und mit einer Stromquelleneinheit (E) zur Anlegung einer Vorwärts- bzw. Durchlaßspannung an einen zwischen dem Halbleitersubstrat (8) und der Sourcezone (10) gebildeten PN-Übergang, dadurch · gekennzeichnet, daß die Durchlaßspannung im wesentlichen konstant und nicht größer ist als eine eingebaute (interne) Potentialdifferenz am PN-Übergang.

2. Halbleiterschaltungsvorrichtung nach Anspruch 1, mit einem zweiten Isolierschicht-Feldeffekttransistor (40) desselben Kanaltyps wie beim ersten Isolierschicht-Feldeffekttransistor (2), dadurch gekennzeichnet, daß der zweite Isolierschicht-Feldeffekttransistor eine mit der Stromstrecke des ersten Isolierschicht-Feldeffekttransistors (2) in Reihe geschaltete Stromstrecke aufweist.

3. Halbleiterschaltungsvorrichtung nach Anspruch 1 oder 2, dadurch gekennzeichnet, daß der erste Isolierschicht-Feldeffekttransistor (2) vom N-Kanaltyp ist.

4. Halbleiterschaltungsvorrichtung nach Anspruch 1 oder 2, dadurch gekennzeichnet, daß die Sourcezone (10) des ersten Isolierschicht-Feldeffekttransistors (20) an Masse liegt und daß Eingangs- und Ausgangsklemme (4 bzw. 6) mit Gate-Elektrode (14) bzw. Drainzone (12) des ersten Isolierschicht-Feldeffekttransistors (2) verbunden sind.

5. Halbleiterschaltungsvorrichtung nach Anspruch 1 oder 2, dadurch gekennzeichnet, daß die Stromquelleneinheit (E) in den PN-Übergang eine die Schwellenwertspannung des ersten Isolierschicht-Feldeffekttransistors (2) übersteigende Spannung anlegt.

6. Halbleiterschaltungsvorrichtung mit einem ersten Isolierschicht-Feldeffekttransistor (20) und einem zweiten, denselben Kanaltyp wei der erste Isolierschicht-Feldeffekttransistor (20) aufweisenden Isolierschicht-Feldeffekttransistor (22), dessen Gate-Elektrode, Drainzone und Sourcezone mit Drainzone, Gate-Elektrode bzw. Sourcezone des ersten Isolierschicht-Feldeffekttransistors verbunden sind, gekennzeichnet, durch eine Stromquelleneinheit (E), die an erste und zweite, zwischen den Substraten und den Sourcezonen von erstem bzw. zweitem Isolierschicht-Feldeffekttransistor (20 bzw. 22) gebildete PN-Übergänge eine im wesentlichen konstante Spannung, die nicht größer ist als die eingebauten (internen) Potentialdifferenzen an erstem bzw. zweitem PN-Übergang, anlegt.

7. Halbleiterschaltungsvorrichtung nach Anspruch 6, dadurch gekennzeichnet, daß die Stromquelleneinheit (E) an ersten und zweiten PN-Übergang eine die Schwellenwertspannungen von ersten und zweitem Isolierschicht-Feldeffekttransistor (20 bzw. 22) übersteigende Spannung anlegt.

8. Halbleiterschaltungsvorrichtung nach Anspruch 6 oder 7, mit einer ersten Bitleitung (28), einer Wortleitung (32) und einem dritten Isolierschicht-Feldeffekttransistor (24), dadurch gekennzeichnet, daß der dritte Isolierschicht-Feldeffekttransistor (24) eine zwischen die Drainelektrode des ersten Isolierschicht-Feldeffekttransistors (20) und die erste Bitleitung (28) geschaltete Stromstrecke sowie eine an die Wortleitung (32) angeschlossene Gate-Elektrode aufweist.

9. Halbleiterschaltungsvorrichtung nach Anspruch 8, mit einer zweiten Bitleitung (30) und einem vierten Isolierschicht-Feldeffektransistor (26), dadurch gekennzeichnet, daß der vierte Isolierschicht-Feldeffekttransistor (26) eine zwischen die Drainelektrode des zweiten Isolierschicht-Feldeffekttransistors (22) und die zweite Bitleitung (30) geschaltete Stromstrecke sowie eine an die Wortleitung (32) angeschlossene Gate-Elektrode aufweist.

**Revendications**

1. Un dispositif à circuit semiconducteur comprenant: des bornes d'entrée et de sortie, un premier transistor à effet de champ à grille isolée (2, 20) ayant un substrat semiconducteur (8), des régions de source et de drain (10, 12) formées dans la région de surface du substrat semiconducteur (8), une électrode de grille (14) placée de façon isolée sur le substrat semiconducteur (8) entre les régions de source et de drain (10, 12), cette électrode de grille (14) et la région de drain (12) étant respectivement connectées aux bornes d'entrée et de sortie, et une source d'énergie (E) destinée à appliquer une tension directe à une jonction PN formée entre le substrat semiconducteur (8) et la région de source (10), caractérisé en ce que la tension directe est pratiquement constante et n'est pas supérieurs à une différence de potentiel inhérente à la jonction PN.

2. Un dispositif à circuit semiconducteur selon la revendication 1, comprenant en outre un second transistor à effet de champ à grille isolée (40), avec le même type de canal que le premier transistor à effet de champ à grille isolée (2), caractérisé en ce que le second transistor à effet de champ à grille isolée comporte un chemin de circulation de courant connecté en série avec le chemin de circulation de courant du premier transistor à effet de champ à grille isolée (2).

3. Un dispositif à circuit semiconducteur selon la revendication 1 ou 2, caractérisé en ce que le premier transistor à effet de champ à grille isolée (2) est du type à canal N.

4. Un dispositif à circuit semiconducteur selon la revendication 1 ou 2, caractérisé en ce que la région de source (10) du premier transistor à effet de champ à grille isolée (2) est reliée à la masse, et en ce que les bornes d'entrée et de sortie (4 et 6) sont respectivement connectées à l'électrode de grille (14) et à la région de drain (12) du premier transistor à effet de champ à grille isolée (2).

5. Un dispositif à circuit semiconducteur selon la revendication 1 ou 2, caractérisé en ce que la source d'énergie (E) applique à la jonction PN une tension supérieure à une tension de seuil du premier transistor à effet de champ à grille isolée (2).

6. Un circuit semiconducteur comprenant un premier transistor à effet de champ à grille isolée (20) et un second transistor à effet de champ à grille isolée (22) du même type de canal que le premier transistor à effet de champ à grille isolée (20), dont l'électrode de grille, la région de drain et la région de source sont respectivement connectées à la région de drain, l'électrode de grille et la région de source du premier transistor à effet de champ à grille isolée, caractérisé en ce qu'il comprend en outre une source d'énergie (E) destinée à appliquer aux première et seconde jonctions PN, formées respectivement entre les substrats et les régions de source des premier et second transistors à effet de champ à grille isolée (20, 22), une tension pratiquement constante qui n'est pas supérieure aux différences de potentiel inhérentes aux première et seconde jonctions PN.

7. Un circuit semiconducteur selon la revendication 6, caractérisé en ce que la source d'énergie (E) applique aux première et seconde jonctions PN une tension supérieure aux tensions de seuil des premier et second transistors à effet de champ à grille isolée (20, 22).

8. Un circuit semiconducteur selon la revendication 6 ou 7, comprenant en outre une première ligne de bit (28), une ligne de mot (32) et un troisième transistor à effet de champ à grille isolée (24), caractérisé en ce que le troisième transistor à effet de champ à grille isolée (24) comporte un chemin de circulation de courant qui est connecté entre le drain du premier transistor à effet de champ à grille isolée (20) et la première ligne de bit (28), et une grille qui est connectée à la ligne de mot (32).

9. Un circuit semiconducteur selon la revendication 8, comprenant en outre une seconde ligne de bit (30) et un quatrième transistor à effet de champ à grille isolée (26), caractérisé en ce que le quatrième transistor à effet de champ à grille isolée (26) comporte un chemin de circulation du courant qui est connecté entre le drain du second transistor à effet de champ à grille isolée (22) et la seconde ligne de bit (30), et une grille qui est connectée à la ligne de mot (32).

FIG. 1

FIG. 2

FIG. 3

FIG. 4

1

# F I G. 5

# F I G. 6

# F I G. 7